# EUROPEAN PATENT APPLICATION

(11) **EP 3 246 428 A1**
(43) Date of publication of application: **22.11.2017**
(21) Application number: 16737228.3
(22) Date of filing: 04.01.2016
(51) Int. Cl.: C23C 16/36, C23C 16/42, H01L 21/318, C07F 7/10

(54) **METHOD FOR MANUFACTURING METAL CARBONITRIDE FILM OR METALLOID CARBONITRIDE FILM, METAL CARBONITRIDE FILM OR METALLOID CARBONITRIDE FILM, AND APPARATUS FOR MANUFACTURING METAL CARBONITRIDE FILM OR METALLOID CARBONITRIDE FILM**

(30) Priority: 14.01.2015 JP 2015004617; 29.01.2015 JP 2015015194
(71) Applicant: Ube Industries, Ltd., Ube-shi, Yamaguchi 755-8633 (JP)
(72) Inventor: SHIRAI Masashi, Ube-shi Yamaguchi 755-8633 (JP); NIHEI Hiroshi, Ube-shi Yamaguchi 755-8633 (JP)
(74) Representative: Merkle, Gebhard
(86) International application number: PCT/JP2016/050050
(87) International publication number: WO 2016/114157

(57) **Abstract**

Provided is a method capable of manufacturing a metal carbonitride film or a metalloid carbonitride film at low temperature. A metal carbonitride film or a metalloid carbonitride film is formed using as a nitrogen source at least one of an N-trialkylsilyl-1,2,3-triazole compound and a 1,2,4-triazole compound represented by the following general formula (1): 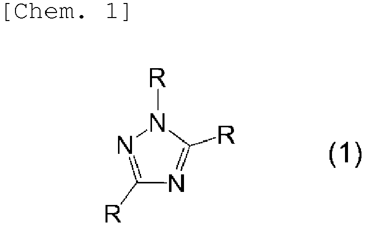 where Rs are the same or different, each represent a hydrogen atom, a linear, branched or cyclic alkyl group of 1 to 5 carbon atoms or a trialkylsilyl group of 1 to 5 carbon atoms, and, depending on circumstances, bond to each other to form a ring.

## Description

### Technical Field

The present invention relates to a method for manufacturing a metal carbonitride film or a metalloid carbonitride film, a metal carbonitride film or a metalloid carbonitride film, and an apparatus for manufacturing a metal carbonitride film or a metalloid carbonitride film.

### Background Art

Recently, in the fields of semiconductors, electronic components, and the like, much research and development has been done on highly chemical-resistant "carbonitride films in which carbon exists in metal nitride films or metalloid nitride films". As methods for manufacturing a metal carbonitride film or a metalloid carbonitride film, there are known, for example, a method for manufacturing it by combining an inorganic nitrogen gas, such as ammonia, and a hydrocarbon gas, such as acetylene (see, for example, Patent Literature 1) and a method in which isopropylamine is used as a supply source of carbon and nitrogen (carbonitriding agent) (see, for example, Patent Literature 2).

Furthermore, there are disclosed methods in which aminosilane (see, for example, Patent Literatures 3 to 5) is used as a carbonitriding agent for manufacturing a silicon carbonitride film.

### Citation List

### Patent Literature

Patent Literature 1: JP-A-2007-189173
Patent Literature 2: JP-A-2009-283587
Patent Literature 3: JP-A-2014-177471
Patent Literature 4: JP-A-2010-267971
Patent Literature 5: JP-A-2010-43081

### Summary of Invention

### Technical Problem

However, in the method where an inorganic nitrogen gas and a hydrocarbon gas are used, there are problems, such as the necessity of separately providing respective means for supplying the respective gases and the necessity for high temperatures of 600°C or more during film formation.

On the other hand, in the method where aminosilane is used, there is a problem that a substrate incapable of resisting plasma cannot be selected because the method is performed in a plasma atmosphere.

A principal object of the present invention is to provide a method capable of manufacturing a metal carbonitride film or a metalloid carbonitride film at low temperature.

### Solution to Problem

In a method for manufacturing a metal carbonitride film or a metalloid carbonitride film according to the present invention, a metal carbonitride film or a metalloid carbonitride film is formed using as a nitrogen source at least one of an N-trialkylsilyl-1,2,3-triazole compound and a 1,2,4-triazole compound represented by the following general formula (1): 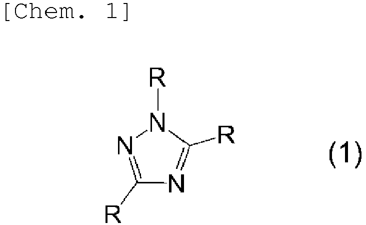 where Rs are the same or different, each represent a hydrogen atom, a linear, branched or cyclic alkyl group of 1 to 5 carbon atoms or a trialkylsilyl group of 1 to 5 carbon atoms, and, depending on circumstances, bond to each other to form a ring.

A metal carbonitride film or a metalloid carbonitride film according to the present invention is one obtained by the method for manufacturing a metal carbonitride film or a metalloid carbonitride film according to the present invention.

An apparatus for manufacturing a metal carbonitride film or a metalloid carbonitride film according to the present invention is an apparatus for manufacturing a metal carbonitride film or a metalloid carbonitride film for use in the method for manufacturing a metal carbonitride film or a metalloid carbonitride film according to the present invention. The apparatus for manufacturing a metal carbonitride film or a metalloid carbonitride film according to the present invention includes a reaction chamber, a metal or metalloid source supplying section, and a nitrogen source supplying section. The reaction chamber includes a placement section in which a film formation object is to be placed. The metal or metalloid source supplying section supplies a metal source or a metalloid source into the reaction chamber. The nitrogen source supplying section supplies the nitrogen source into the reaction chamber. Advantageous Effects of Invention

According to the present invention, it is possible to provide a method capable of manufacturing a metal carbonitride film or a metalloid carbonitride film at low temperature. Brief Description of Drawings

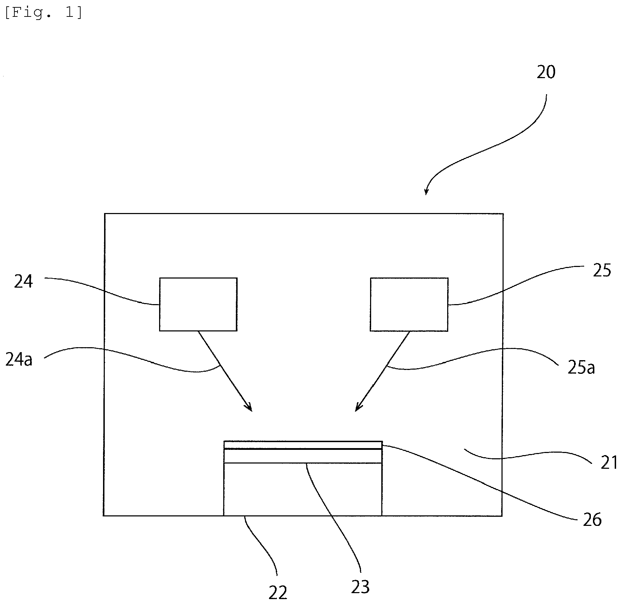

[Fig. 1] Fig. 1 is a schematic view showing an apparatus for manufacturing a metal carbonitride film or a metalloid carbonitride film according to one embodiment of the present invention.

### Description of Embodiments

In a method for manufacturing a metal carbonitride film or a metalloid carbonitride film, a metal carbonitride film or a metalloid carbonitride film is formed using as a nitrogen source at least one of an N-trialkylsilyl-1,2,3-triazole compound and a 1,2,4-triazole compound represented by the following general formula (1): 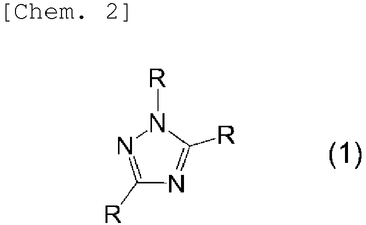 where Rs are the same or different, each represent a hydrogen atom, a linear, branched or cyclic alkyl group of 1 to 5 carbon atoms or a trialkylsilyl group of 1 to 5 carbon atoms, and, depending on circumstances, bond to each other to form a ring.

Specifically, a metal carbonitride film or a metalloid carbonitride film is formed on a film formation object by supplying a metal or metalloid source and at least one of an N-trialkylsilyl-1,2,3-triazole compound and a 1,2,4-triazole compound represented by the general formula (1). The formation of the metal carbonitride film or the metalloid carbonitride film can be suitably performed, for example, by the chemical vapor deposition process (hereinafter, referred to as the CVD process) or the atomic layer deposition process (hereinafter, referred to as the ALD process).

In the CVD process and the ALD process, a nitrogen source needs to be vaporized in order to form a film on a film formation object. Examples of a method for vaporizing the nitrogen source that can be used include not only a method for vaporizing the nitrogen source by filling or conveying the nitrogen source itself into a vaporizing chamber but also a method for vaporizing the nitrogen source by introducing a solution thereof diluted with a suitable solvent (for example, an aliphatic hydrocarbon, such as hexane, methylcyclohexane, ethylcyclohexane or octane; an aromatic hydrocarbon, such as toluene; or an ether, such as tetrahydrofuran or dibutyl ether) into a vaporizing chamber with a liquid conveying pump (solution method).

More specifically, as shown in Fig. 1, a film 26 is formed by supplying, to a film formation object 23 placed on a placement section 22 provided in a reaction chamber 21 of an apparatus 20 for manufacturing a metal carbonitride film or a metalloid carbonitride film, a metal or metalloid source 24a and a nitrogen source 25a from a metal or metalloid source supplying section 24 and a nitrogen source supplying section 25, respectively, provided inside the reaction chamber 21.

The content of gas of the N-trialkylsilyl-1,2,3-triazole compound or the 1,2,4-triazole compound in the total amount of gas during vapor deposition of the metal carbonitride film or the metalloid carbonitride film is preferably 0.1% to 99% by volume and more preferably 0.5% to 95% by volume.

The internal pressure in the reaction system during formation of the metal carbonitride film or the metalloid carbonitride film is preferably 1 Pa to 200 kPa and more preferably 10 Pa to 110 kPa. The temperature of the film formation object during formation of the metal carbonitride film or the metalloid carbonitride film is preferably 100 to 600°C and more preferably 200 to 500°C. The temperature for vaporizing the N-trialkylsilyl-1,2,3-triazole compound or the 1,2,4-triazole compound during formation of the metal carbonitride film or the metalloid carbonitride film is preferably 0°C to 180°C and more preferably 10°C to 100°C.

### (N-Trialkylsilyl-1,2,3-Triazole Compound)

The N-trialkylsilyl-1,2,3-triazole compound is at least one compound selected from the group consisting of compounds represented by the formulas (2) and (3) below. The compounds represented by the formulas (2) and (3) are tautomers. 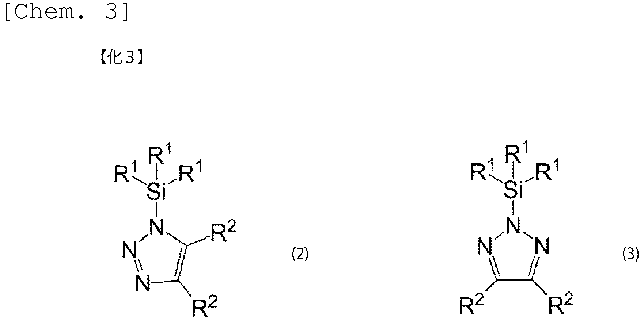 where R¹s are the same or different, each represent a linear, branched or cyclic alkyl group of 1 to 3 carbon atoms, and, depending on circumstances, bond to each other to form a ring, and
where R²s are the same or different, each represent a hydrogen atom, a linear, branched or cyclic alkyl group of 1 to 5 carbon atoms or a trialkylsilyl group of 1 to 5 carbon atoms, and, depending on circumstances, bond to each other to form a ring.

Examples of the linear or branched alkyl group of 1 to 3 carbon atoms include, for example, a methyl group, an ethyl group, an n-propyl group, an isopropyl group, and a cyclopropyl group.

In the formulas (2) and (3), R² is a hydrogen atom, a linear, branched or cyclic alkyl group of 1 to 5 carbon atoms or a trialkylsilyl group of 1 to 5 carbon atoms.

Examples of the linear, branched or cyclic alkyl group of 1 to 5 carbon atoms include, for example, a methyl group, an ethyl group, an n-propyl group, an isopropyl group, an n-butyl group, an isobutyl group, a t-butyl group, a pentyl group, a cyclopropyl group, a cyclobutyl group, and a cyclopentyl group.

Examples of the trialkylsilyl group of 1 to 5 carbon atoms include, for example, a trimethylsilyl group, a triethylsilyl group, a dimethylethylsilyl group, and a methyldiethylsilyl group.

The plurality of R²s may bond to each other to form a ring and examples of the ring to be formed include, for example, saturated or unsaturated rings of 2 to 10 carbon atoms.

The N-trialkylsilyl-1,2,3-triazole compounds that can be preferably used in the present invention are represented, for example, by the formulas (4) to (27) below. The following N-trialkylsilyl-1,2,3-triazole compounds may be used alone or in combination of two or more of them.

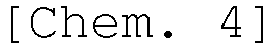

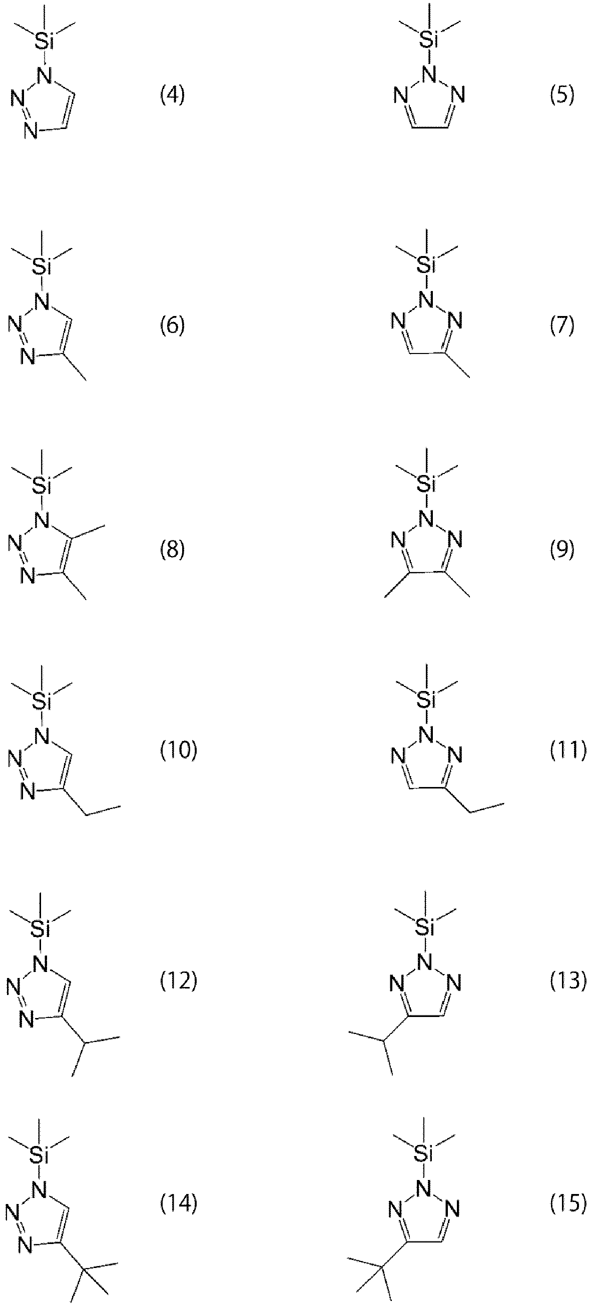

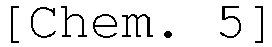

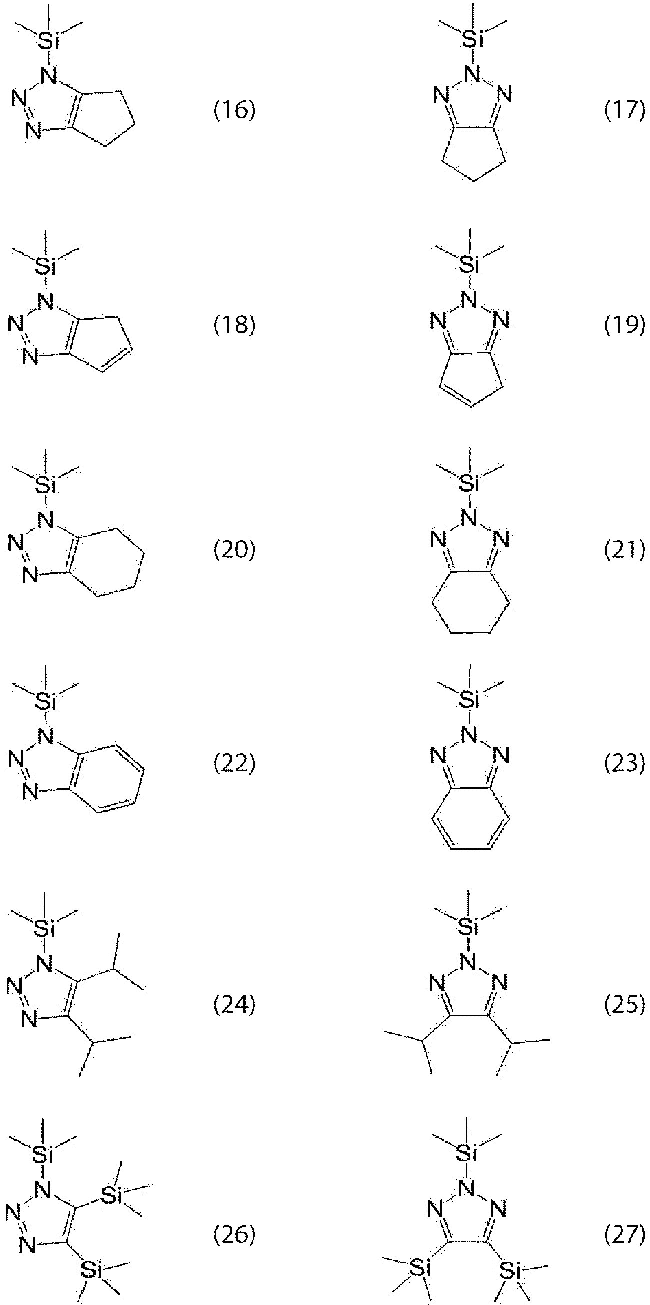

The manufacture of the N-trialkylsilyl-1,2,3-triazole compound can be performed in accordance with a known method (see, for example, MAGNETIC RESONANCE IN CHEMISTRY, Vol. 36, 110, (1998)). According to this, it is disclosed that N-trimethylsilyl-1,2,3-triazole formed by reaction between 1,2,3-triazole and hexamethyldisilazane (bis (trimethylsilyl) amine) is produced as a mixture of two kinds of compounds.

### (1,2,4-Triazole Compound)

The 1,2,4-triazole compound used in the present invention is a compound represented by the following formula (1): 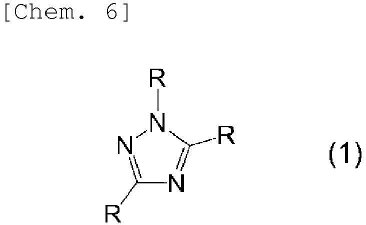 where Rs are the same or different, each represent a hydrogen atom, a linear, branched or cyclic alkyl group of 1 to 5 carbon atoms or a trialkylsilyl group of 1 to 5 carbon atoms, and, depending on circumstances, bond to each other to form a ring.

Examples of the linear, branched or cyclic alkyl group of 1 to 5 carbon atoms include, for example, a methyl group, an ethyl group, an n-propyl group, an isopropyl group, an n-butyl group, an isobutyl group, a t-butyl group, a pentyl group, a cyclopropyl group, a cyclobutyl group, and a cyclopentyl group.

Examples of the trialkylsilyl group of 1 to 5 carbon atoms include, for example, a trimethylsilyl group, a triethylsilyl group, a dimethylethylsilyl group, and a methyldiethylsilyl group.

The plurality of Rs may bond to each other to form a ring and examples of the ring to be formed include, for example, saturated or unsaturated rings of 2 to 10 carbon atoms.

The 1,2,4-triazole compounds that can be preferably used in the present invention are represented, for example, by the formulas (28) to (55) below. The following 1,2,4-triazole compounds may be used alone or in combination of two or more of them.

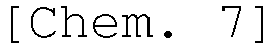

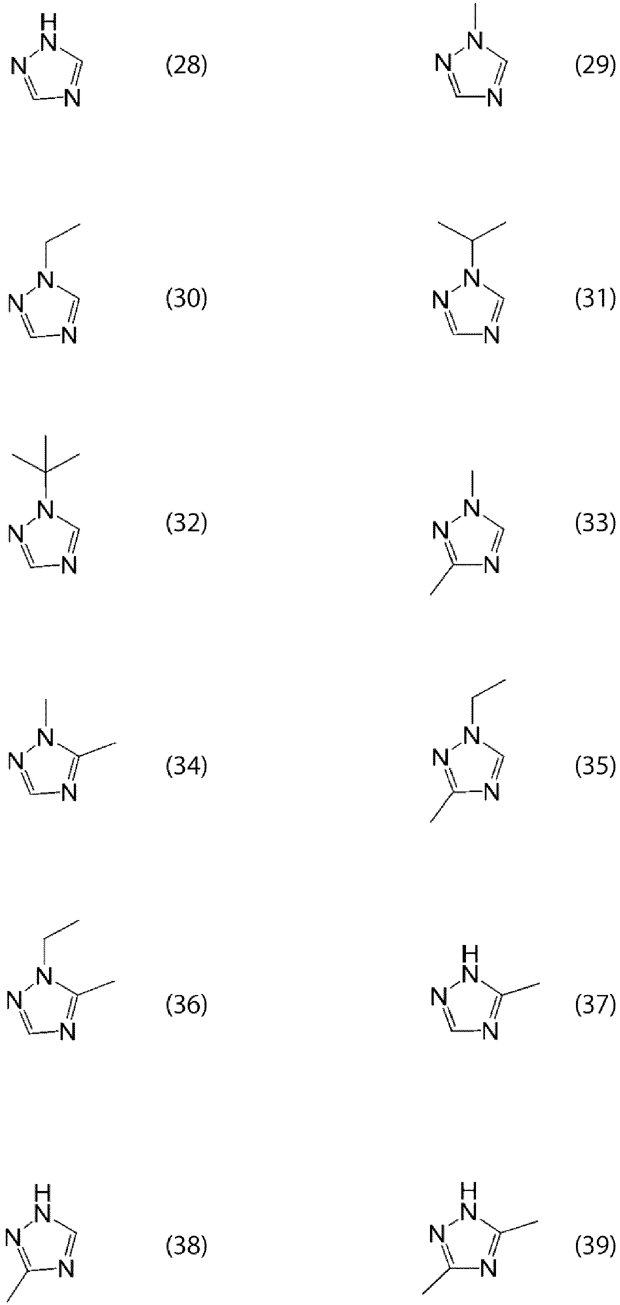

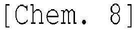

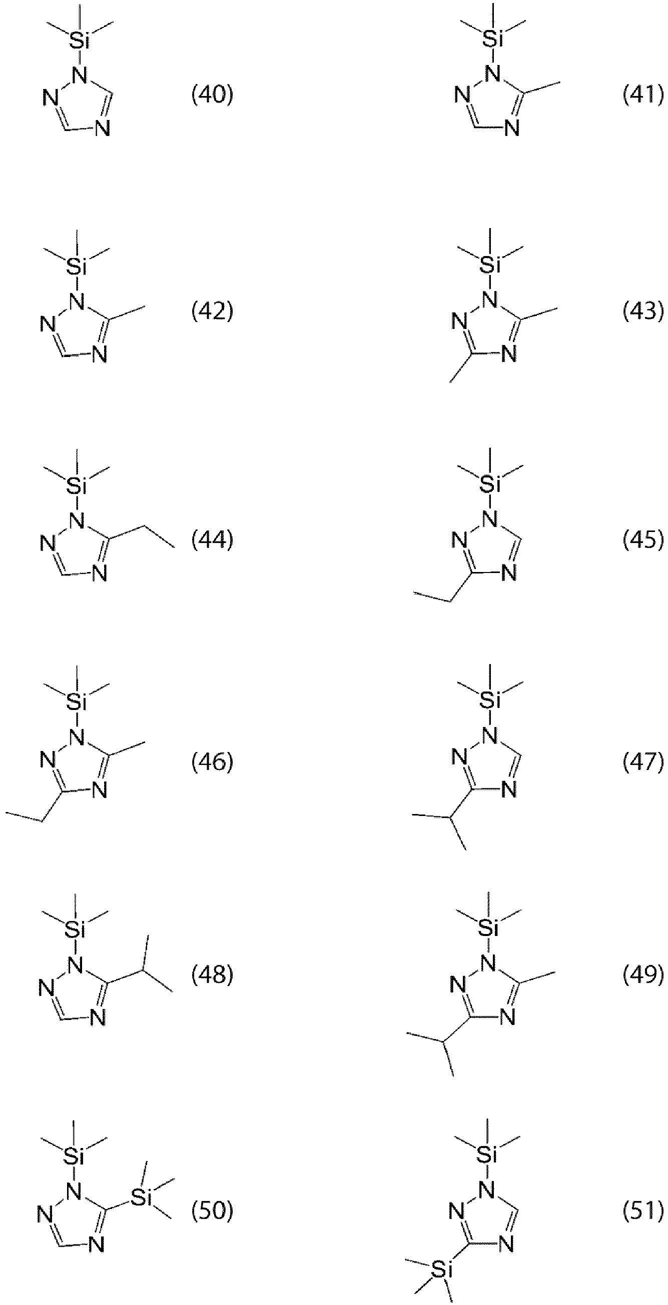

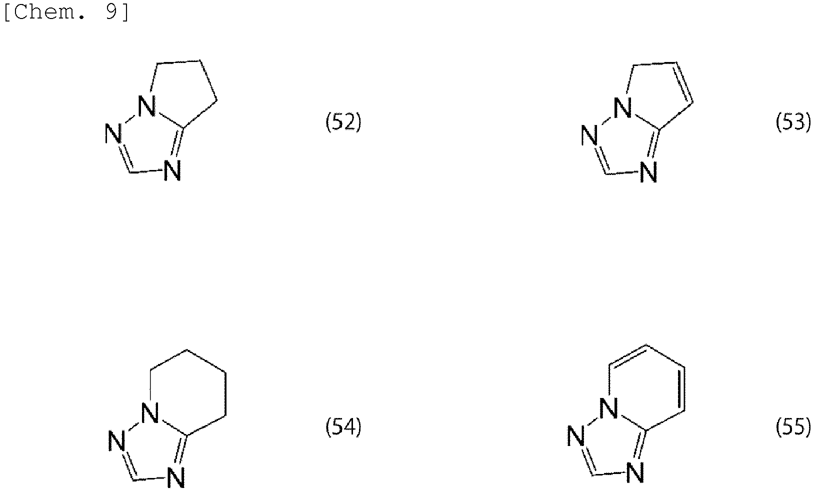

### (Metal Source or Metalloid Source)

The metal source or metalloid source that is preferably used is, for example, a metal halide or a metalloid halide.

Examples of the metal halide include trichloroaluminum, tribromoaluminum, trifluoroaluminum, triiodoaluminum, tetrabromotitanium, tetrachlorotitanium, tetrafluorotitanium, tetraiodotitanium, tetrabromozirconium, tetrachlorozirconium, tetrafluorozirconium, tetraiodozirconium, tetrabromohafnium, tetrachlorohafnium, tetrafluorohafnium, tetraiodohafnium, pentachlorotantalum, pentachloromolybdenum, hexafluoromolybdenum, bis(cyclopentadienyl)dichloromolybdenum, hexachlorotungsten, hexafluorotungsten, dibromocobalt, dichlorocobalt, difluorocobalt, diiodocobalt, dibromonickel, dichloronickel, diiodonickel, dibromomanganese, dichloromanganese, difluoromanganese, diiodomanganese, monobromocopper, dibromocopper, monochlorocopper, dichlorocopper, difluorocopper, diiodocopper, tribromogallium, trichlorogallium, trifluorogallium, triiodogallium, tribromobismuth, trichlorobismuth, trifluorobismuth, triiodobismuth, tribromoruthenium, trichlororuthenium, trifluororuthenium, trichlororhodium, dibromoplatinum, dichloroplatinum, tetrachloroplatinum, diiodoplatinum, dibromopalladium, dichloropalladium, diiodopalladium, triiodoruthenium, benzenedichlororuthenium, dibromozinc, dichlorozinc, difluorozinc, and diiodozinc.

Examples of the metalloid halide include tetrachlorosilane, tetrafluorosilane, hexachlorodisilane, chloropentamethyldisilane, dichlorotetramethyldisilane, monochlorosilane, dichlorosilane, trichlorosilane, tetrabromogermanium, tetrachlorogermanium, tetraiodogermanium, tribromoboron, trichloroboron, trifluoroboron, and triiodoboron.

The method for manufacturing a metal carbonitride film or a metalloid carbonitride film according to the present invention is suitable particularly for manufacturing a silicon carbonitride film.

### (Manufacture of Metal Carbonitride Film or Metalloid Carbonitride Film)

In the CVD process and the ALD process, a nitrogen source needs to be vaporized in order to form a film on a film formation object. Examples of a method for vaporizing the nitrogen source that can be used include not only a method for vaporizing the nitrogen source by filling or conveying the nitrogen source itself into a vaporizing chamber but also a method for vaporizing the nitrogen source by introducing a solution thereof diluted with a suitable solvent (for example, an aliphatic hydrocarbon, such as hexane, methylcyclohexane, ethylcyclohexane or octane; an aromatic hydrocarbon, such as toluene; or an ether, such as tetrahydrofuran or dibutyl ether) into a vaporizing chamber with a liquid conveying pump (solution method).

### Examples

Next, the present invention will be described in concrete terms with reference to examples but the scope of the invention is not limited to these examples.

### Reference Example 1 (N-Trimethylsilyl-1,2,3-Triazole; Synthesis of Mixture of Compounds (4) and (5))

An amount of 8.68 g (125.7 mmol) of 1,2,3-triazole and 10.14 g(62.8 mmol) of hexamethyldisilazane were added into a 100 ml volume flask equipped with a stirrer, a thermometer, and a drip funnel and the mixture liquid was reacted at 145°C to 150°C for two hours with stirring.

After the end of the reaction, the resultant reaction liquid was distilled under reduced pressure (at 120°C and 27 kPa) to obtain 16.07 g of N-trimethylsilyl-1,2,3-triazole as a clear, colorless liquid (isolated yield; 90%).

The values of physical properties of N-trimethylsilyl-1,2,3-triazole were as follows: ¹H-NMR (CDCl₃, δ (ppm)); 0.55 (9H, s), 7.76 (2H, s)

### Examples 1 to 3 (Vapor Deposition Test; Manufacture of Silicon Carbonitride Films)

Each film was formed on a 20 mmx20 mm substrate by the CVD process using the compound shown in Table 1 under the conditions shown in Table 1. Furthermore, the formed film was analyzed by XPS (X-ray Photoelectron Spectroscopy) to identify the film.

**[Table 1]**

| | Film Formation Conditions | Characteristics of Silicon Carbonitride Film |
|---|---|---|
| Example 1 | N-trialkylsilyl-1,2,3-triazole compound; mixture of (4) and (5) | Film thickness; 200nm XPS analysis; silicon carbonitride film |
| | Vaporization temperature of N-trialkylsilyl-1,2,3-triazole compound; 60°C | |
| | Flow rate of Ar carrier for N-trialkylsilyl-1,2,3-triazole compound; 5ml/min. | |
| | Silicon source; hexachlorodisilane | |
| | Vaporization temperature of hexachlorodisilane; 30°C | |
| | Flow rate of Ar carrier for hexachlorodisilane; 5ml/min. | |
| | Substrate material; SiO₂/Si | |
| | Substrate temperature; 500°C | |
| | Internal pressure in reaction system; 3990Pa | |
| | Vapor deposition time; 60 min. | |
| Example 2 | N-trialkylsilyl-1,2,3-triazole compound; mixture of (4) and (5) | Film thickness; 50nm XPS analysis; silicon carbonitride film |
| | Vaporization temperature of N-trialkylsilyl-1,2,3-triazole compound; 60°C | |
| | Flow rate of Ar carrier for N-trialkylsilyl-1,2,3-triazole compound; 5ml/min. | |
| | Silicon source; hexachlorodisilane | |
| | Vaporization temperature of hexachlorodisilane; 30°C | |
| | Flow rate of Ar carrier for hexachlorodisilane; 5ml/min. | |
| | Substrate material; SiO₂/Si | |
| | Substrate temperature; 400°C | |
| | Internal pressure in reaction system; 3990Pa | |
| | Vapor deposition time; 60 min. | |
| Example 3 | N-trialkylsilyl-1,2,3-triazole compound; mixture of (4) and (5) | Film thickness; 10nm XPS analysis; silicon carbonitride film |
| | Vaporization temperature of N-trialkylsilyl-1,2,3-triazole compound; 60°C | |
| | Flow rate of Ar carrier for N-trialkylsilyl-1,2,3-triazole compound; 5ml/min. | |
| | Silicon source; hexachlorodisilane | |
| | Vaporization temperature of hexachlorodisilane; 30°C | |
| | Flow rate of Ar carrier for hexachlorodisilane; 5ml/min. | |
| | Substrate material; SiO₂/Si | |
| | Substrate temperature; 300°C | |
| | Internal pressure in reaction system; 3990Pa | |
| | Vapor deposition time; 60 min. | |

It can be seen from the results in Examples 1 to 3 that with the use of an N-trialkylsilyl-1,2,3-triazole compound, a silicon carbonitride film can be manufactured at low temperature.

### Reference Example 2 (N-Trimethylsilyl-1,2,4-Triazole; Synthesis of Compound (40))

An amount of 5.00 g (72.4 mmol) of 1,2,4-triazole and 5.84 g(32.6 mmol) of hexamethyldisilazane were added into a 100 ml volume flask equipped with a stirrer, a thermometer, and a drip funnel and the mixture liquid was reacted at 145 to 150°C for four hours with stirring.

After the end of the reaction, the resultant reaction liquid was distilled under reduced pressure (at 120°C and 6.7 kPa) to obtain 5.33 g of N-trimethylsilyl-1,2,4-triazole as a clear, colorless liquid (isolated yield; 52%).

The values of physical properties of N-trimethylsilyl-1,2,4-triazole were as follows: ¹H-NMR (CDCl₃, δ (ppm)); 0.50 (9H, s), 8.09 (1H, s), 8.21 (1H, s)

### Examples 4 to 8 (Vapor Deposition Test; Manufacture of Silicon Carbonitride Films)

Each film was formed on a 20 mm x 20 mm substrate by the CVD process using the compound shown in Table 2 under the conditions shown in Table 1. Furthermore, the formed film was analyzed by XPS (X-ray Photoelectron Spectroscopy) to identify the film.

**[Table 2]**

| | Film Formation Conditions | Characteristics of Silicon Carbonitride Film |
|---|---|---|
| Example 4 | 1,2,4-triazole compound; (28) | Film thickness; 300nm XPS analysis; silicon carbonitride film |
| | Vaporization temperature of 1,2,4-triazole compound; 120°C | |
| | Flow rate of Ar carrier for 1,2,4-triazole compound; 5ml/min. | |
| | Silicon source; hexachlorodisilane | |
| | Vaporization temperature of hexachlorodisilane; 30°C | |
| | Flow rate of Ar carrier for hexachlorodisilane; 5ml/min. | |
| | Substrate material; SiO₂/Si | |
| | Substrate temperature; 500°C | |
| | Internal pressure in reaction system; 3990Pa | |
| | Vapor deposition time; 60 min. | |
| Example 5 | 1,2,4-triazole compound; (28) | Film thickness; 100nm XPS analysis; silicon carbonitride film |
| | Vaporization temperature of 1,2,4-triazole compound; 120°C | |
| | Flow rate of Ar carrier for 1,2,4-triazole compound; 5ml/min. | |
| | Silicon source; hexachlorodisilane | |
| | Vaporization temperature of hexachlorodisilane; 30°C | |
| | Flow rate of Ar carrier for hexachlorodisilane; 5ml/min. | |
| | Substrate material; SiO₂/Si | |
| | Substrate temperature; 350°C | |
| | Internal pressure in reaction system; 3990Pa | |
| | Vapor deposition time; 60 min. | |
| Example 6 | 1,2,4-triazole compound; (40) | Film thickness; 300nm XPS analysis; silicon carbonitride film |
| | Vaporization temperature of 1,2,4-triazole compound; 100°C | |
| | Flow rate of Ar carrier for 1,2,4-triazole compound; 5ml/min. | |
| | Silicon source; hexachlorodisilane | |
| | Vaporization temperature of hexachlorodisilane; 30°C | |
| | Flow rate of Ar carrier for hexachlorodisilane; 5ml/min. | |
| | Substrate material; SiO₂/Si | |
| | Substrate temperature; 500°C | |
| | Internal pressure in reaction system; 3990Pa | |
| | Vapor deposition time; 60 min. | |
| Example 7 | 1,2,4-triazole compound; (40) | Film thickness; 100nm XPS analysis; silicon carbonitride film |
| | Vaporization temperature of 1,2,4-triazole compound; 100°C | |
| | Flow rate of Ar carrier for 1,2,4-triazole compound; 5ml/min. | |
| | Silicon source; hexachlorodisilane | |
| | Vaporization temperature of hexachlorodisilane; 30°C | |
| | Flow rate of Ar carrier for hexachlorodisilane; 5ml/min. | |
| | Substrate material; SiO₂/Si | |
| | Substrate temperature; 350°C | |
| | Internal pressure in reaction system; 3990Pa | |
| | Vapor deposition time; 60 min. | |
| Example 8 | 1,2,4-triazole compound; (40) | Film thickness; 50nm XPS analysis; silicon carbonitride film |
| | Vaporization temperature of 1,2,4-triazole compound; 100°C | |
| | Flow rate of Ar carrier for 1,2,4-triazole compound; 5ml/min. | |
| | Silicon source; hexachlorodisilane | |
| | Vaporization temperature of hexachlorodisilane; 30°C | |
| | Flow rate of Ar carrier for hexachlorodisilane; 5ml/min. | |
| | Substrate material; SiO₂/Si | |
| | Substrate temperature; 250°C | |
| | Internal pressure in reaction system; 3990Pa | |
| | Vapor deposition time; 60 min. | |

It can be seen from the results in Examples 4 to 8 that with the use of a 1,2,4-triazole compound, a silicon carbonitride film can be manufactured at low temperature.

### Reference Signs List

20 apparatus for manufacturing a metal carbonitride film or a metalloid carbonitride film
21 reaction chamber
22 placement section
23 film formation object
24 metal or metalloid source supplying section
24a metal or metalloid source
25 nitrogen source supplying section
25a nitrogen source
26 film

## Claims

1. A method for manufacturing a metal carbonitride film or a metalloid carbonitride film, the method comprising forming a metal carbonitride film or a metalloid carbonitride film using as a nitrogen source at least one of an N-trialkylsilyl-1,2,3-triazole compound and a 1,2,4-triazole compound represented by the following general formula (1): 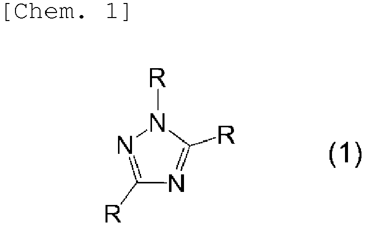 where Rs are the same or different, each represent a hydrogen atom, a linear, branched or cyclic alkyl group of 1 to 5 carbon atoms or a trialkylsilyl group of 1 to 5 carbon atoms, and, depending on circumstances, bond to each other to form a ring.

2. The method for manufacturing a metal carbonitride film or a metalloid carbonitride film according to claim 1, wherein the N-trialkylsilyl-1,2,3-triazole compound is at least one compound selected from the group consisting of compounds represented by the following formulas (2) and (3): 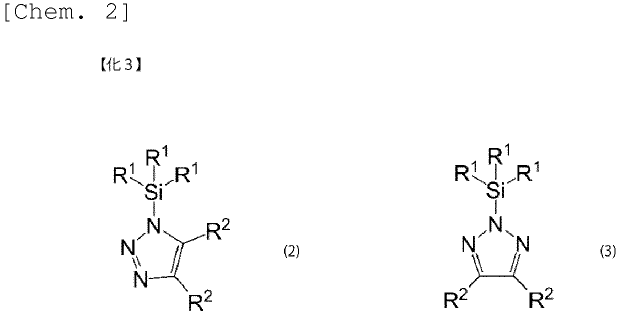 where R¹s are the same or different, each represent a linear, branched or cyclic alkyl group of 1 to 3 carbon atoms, and, depending on circumstances, bond to each other to form a ring, and
where R²s are the same or different, each represent a hydrogen atom, a linear, branched or cyclic alkyl group of 1 to 5 carbon atoms or a trialkylsilyl group of 1 to 5 carbon atoms, and, depending on circumstances, bond to each other to form a ring.

3. The method for manufacturing a metal carbonitride film or a metalloid carbonitride film according to claim 1 or 2, wherein a silicon carbonitride film is formed as the metalloid carbonitride film.

4. The method for manufacturing a metal carbonitride film or a metalloid carbonitride film according to any one of claims 1 to 3, wherein a solution of at least one of an N-trialkylsilyl-1,2,3-triazole compound and a 1,2,4-triazole compound represented by the general formula (1) using as a solvent at least one selected from the group consisting of aliphatic hydrocarbons, aromatic hydrocarbons, and ethers is used as a supply source of nitrogen.

5. The method for manufacturing a metal carbonitride film or a metalloid carbonitride film according to any one of claims 1 to 4, wherein a metal carbonitride film or a metalloid carbonitride film is formed on a film formation object by supplying a metal or metalloid source and at least one of an N-trialkylsilyl-1,2,3-triazole compound and a 1,2,4-triazole compound represented by the general formula (1).

6. The method for manufacturing a metal carbonitride film or a metalloid carbonitride film according to claim 5, wherein a metal halide or a metalloid halide is supplied as the metal or metalloid source.

7. The method for manufacturing a metal carbonitride film or a metalloid carbonitride film according to any one of claims 1 to 6, wherein a film formation temperature for the metal carbonitride film or the metalloid carbonitride film is below 600°C.

8. The method for manufacturing a metal carbonitride film or a metalloid carbonitride film according to claim 7, wherein the film formation temperature for the metal carbonitride film or the metalloid carbonitride film is below 550°C.

9. The method for manufacturing a metal carbonitride film or a metalloid carbonitride film according to claim 8, wherein the film formation temperature for the metal carbonitride film or the metalloid carbonitride film is not more than 500°C.

10. A metal carbonitride film or metalloid carbonitride film obtained by the manufacturing method according to any one of claims 1 to 9.

11. The metal carbonitride film or metalloid carbonitride film according to claim 10, wherein the metalloid is silicon.

12. An apparatus for manufacturing a metal carbonitride film or a metalloid carbonitride film, the apparatus being for use in the method for manufacturing a metal carbonitride film or a metalloid carbonitride film according to any one of claims 1 to 11, the apparatus comprising:
a reaction chamber including a placement section in which a film formation object is to be placed;
a metal or metalloid source supplying section that supplies the metal source or the metalloid source into the reaction chamber; and
a nitrogen source supplying section that supplies the nitrogen source into the reaction chamber.
